# EUROPÄISCHE PATENTSCHRIFT

(11) **EP 1 040 482 B1**
(45) Veröffentlichungstag und Bekanntmachung des Hinweises auf die Patenterteilung: **10.10.2001**
(21) Anmeldenummer: 98961078.7
(22) Anmeldetag: 11.11.1998
(51) Int. Cl.: G11C 5/14, H02J 9/06

(54) **INTEGRIERTE SPEICHERSCHALTUNG MIT EINER PUFFERSCHALTUNG**
INTEGRATED-CIRCUIT MEMORY WITH A BUFFER CIRCUIT
CIRCUIT INTEGRE DE MEMOIRE DOTE D'UN CIRCUIT DE TAMPON

(30) Priorität: 15.12.1997 DE 19755737
(43) Veröffentlichungstag der Anmeldung: 04.10.2000
(73) Patentinhaber: Infineon Technologies AG, 81669 München (DE)
(72) Erfinder: SAVIGNAC, Dominique, D-85737 Ismaning (DE); FEURLE, Robert, D-85635 Höhenkirchen (DE); SCHNEIDER, Helmut, D-80993 München (DE)
(74) Vertreter: Zedlitz, Peter, Dipl.-Inf.
(86) Internationale Anmeldenummer: DE9803306
(87) Internationale Veröffentlichungsnummer: WO9931664

(56) Entgegenhaltungen:
- US-A- 3 753 001
- "ACTIVE LOW DISSIPATION POWER SUPPLY REGULATOR" IBM TECHNICAL DISCLOSURE BULLETIN., Bd. 12, Nr. 4, September 1969, Seite 515 XP002103045 NEW YORK US
- PATENT ABSTRACTS OF JAPAN vol. 013, no. 073 (P-830), 20. Februar 1989 & JP 63 257088 A (NEC CORP), 24. Oktober 1988
- PATENT ABSTRACTS OF JAPAN vol. 018, no. 060 (E-1499), 31. Januar 1994 & JP 05 276683 A (MATSUSHITA ELECTRIC WORKS LTD), 22. Oktober 1993
- PATENT ABSTRACTS OF JAPAN vol. 018, no. 073 (E-1503), 7. Februar 1994 & JP 05 284670 A (NEC CORP), 29. Oktober 1993
- PATENT ABSTRACTS OF JAPAN vol. 015, no. 071 (P-1168), 19. Februar 1991 & JP 02 292797 A (HITACHI LTD;OTHERS: 01), 4. Dezember 1990

## Beschreibung

Die Erfindung betrifft einen integrierten Speicher mit einer Pufferschaltung für eine Versorgungsspannung gemäß dem Oberbegriff des Anspruchs 1. Derartige Speicher sind beispielsweise als DRAMs (Dynamic Random Accesss Memories) allgemein bekannt.

Um Einbrüche bei Versorgungsspannungen von integrierten Schaltungen bei plötzlich auftretenden starken Belastungen oder infolge des kurzzeitigen Versagens der Spannungsversorgungen entgegenzuwirken, ist es bekannt, Pufferkondensatoren zum Puffern der Versorgungsspannung vorzusehen. Diese werden in der Regel so angeordnet, daß die gesamte zu puffernde Versorgungsspannung über dem Pufferkondensator abfällt. Aufgrund von Herstellungsfehlern oder aufgrund von während des Betriebs auftretender Überspannungen kann es vorkommen, daß die Kondensatorelektroden nicht vollständig voneinander isoliert sind, so daß ein von der Versorgungsspannung getriebener Leck- bzw. Kurzschlußstrom über den Kondensator fließt. Dies kann zum Einbrechen der Versorgungsspannung führen. Ein derartiger Defekt kann bewirken, daß die gesamte integrierte Schaltung unbrauchbar wird.

Das Problem verschärft sich noch, wenn die für das Puffern notwendige Kapazität durch die Parallelschaltung zahlreicher Kondensatoren erzielt wird. Dann reicht bereits der Defekt eines einzigen der Kondensatoren aus, um den gesamten Chip wegen des damit verbundenen Kurzschlusses der Versorgungsspannung unbrauchbar zu machen.

In Patent Abstracts of Japan, vol. 018, no. 073 (E-1503), 7. Februar 1994, betreffend die JP 05-284 670 A, ist eine Pufferschaltung für eine Batterieversorgung eines ICs beschrieben, die zwei parallel geschaltete RC-Reihenschaltungen aufweist.

Der Erfindung liegt die Aufgabe zugrunde, einen integrierten Speicher für die Versorgungsspannung anzugeben, bei der eine Beeinträchtigung des integrierten Speichers auf Grund eines in der Pufferschaltung auftretenden Defektes weitestgehend vermieden wird.

Diese Aufgabe wird mit einem integrierten Speicher gemäß Anspruch 1 gelöst. Vorteilhafte Aus- und Weiterbildungen der Erfindung sind Gegenstand von abhängigen Ansprüchen.

Die Pufferschaltung, wie sie im erfindungsgemäßen Speicher verwendet wird, weist eine Reihenschaltung aus einem hochohmigen Widerstandselement und einem Pufferkondensator auf, an der die zu puffernde Versorgungsspannung anliegt. Kommt es zu einem Defekt des Pufferkondensators, ergibt sich der Gesamtwiderstand der Pufferschaltung aus der Summe des Kurzschlußwiderstandes des Kondensators und des Widerstandswertes des Widerstandelementes. Ist der Widerstandswert des Widerstandelements ausreichend hoch gewählt, wird verhindert, daß im Defektfall ein zu großer Strom über die Pufferschaltung fließt. Das Widerstandselement ist so dimensioniert, daß der bei einem Defekt des Kondensators auftretende Leckstrom auf einen gewünschten Maximalwert begrenzt ist. Daher kann auch dann, wenn die Pufferschaltung ihre Pufferfunktion auf Grund eines Defekts des Kondensators nicht mehr ausüben kann, die Versorgungsspannung vor dem Zusammenbruch bewahrt werden, so daß die integrierten Schaltung weiterhin eingesetzt werden kann.

Das hochohmige Widerstandselement ist gemäß Anspruch 1 ein Transistor. Der Widerstandwert des Widerstandselementes kann über einen Steueranschluß veränderbar sein.

Im letztgenannten Fall sieht eine Weiterbildung der Erfindung vor, daß die Pufferschaltung eine Steuerschaltung aufweist, die den Widerstandswert des Widerstandselementes über seinen Steueranschluß steuert. Dies hat den Vorteil, daß sein Widerstandswert an bestimmte Wünsche oder auftretende Defekte des Kondensators anpaßbar ist.

In einer Ausführungsform ist die Steuerschaltung ein Spannungsregler, der den Widerstandswert des Widerstandselementes in Abhängigkeit vom Potential am zweiten Potentialknoten steuert. In diesem Fall wird günstigerweise bei einem Einbruch der Versorgungsspannung aufgrund eines Defekts des Pufferkondensators der Widerstandswert solange erhöht, bis der durch die Reihenschaltung fließende Leckstrom die Versorgungsspannung nicht mehr nennenswert beeinträchtigt.

In einer anderen Ausführungsform ist die Steuerschaltung ein Stromregler, der den Widerstandswert des Widerstandselementes in Abhängigkeit vom Stromfluß durch die Reihenschaltung steuert. Die Wirkung entspricht derjenigen der zuvor geschilderten Ausführungsform. Beide Ausführungsformen heben den Vorteil, daß die Pufferschaltung flexibel auf auftretende Defekte ihres Kondensators reagiert. Es kann vorgesehen sein, daß der Spannungs- bzw. Stromregler den Widerstandswert des Widerstandselementes erst erhöht, wenn das Potential am zweiten Knoten um einen Mindestbetrag gefallen ist bzw. wenn der Leckstrom eine Mindeststärke erreicht hat.

In einer weiteren Ausführungsform ist die Steuerschaltung eine einstellbare Spannungsquelle, die an ihrem Ausgang eine über einen Steuereingang einstellbare Ausgangsspannung erzeugt, wobei der Ausgang mit dem Steueranschluß des Widerstandselementes verbunden ist. Die Ausgangsspannung der Spannungsquelle ist entweder einmalig oder wiederholt einstellbar. Sie kann nach dem oder im Verlauf des Herstellprozesses der Pufferschaltung bzw. der sie beinhaltenden integrierten Schaltung so gewählt werden, daß der Widerstandswert des Transistors an zuvor festgestellte herstellungsbedingte Einflüsse oder an festgestellte Defekte des Pufferkondensators angepaßt wird. Auf diese Weise lassen sich herstellungsbedingte Einflüsse auf die Funktion der Pufferschaltung ausschließen und festgestellte Defekte kompensieren. Die einstellbare Spannungsquelle kann z.B. programmierbar sein.

Eine besonders vorteilhafte Weiterbildung der Erfindung sieht vor, daß die Pufferschaltung wenigstens zwei Reihenschaltungen mit je einem Pufferkondensator und einem hochohmigen Widerstandselement aufweist, wobei alle diese Reihenschaltungen einander parallel geschaltet sind, und die zu puffernde Versorgungsspannung über dieser Parallelschaltung abfällt. Diese Weiterbildung hat den Vorteil, daß bei Defekt einzelner der Kondensatoren deren Kurzschlußstrom jeweils durch das ihnen zugeordnete Widerstandselement begrenzt wird. Es entsteht also aufgrund des Widerstandelementes kein niederohmiger Kurzschluß parallel zu den intakten Reihenschaltungen. Daher bleibt die Wirkung der intakten Pufferkondensatoren vom Ausfall der defekten Pufferkondensatoren unbeeinflußt. Die Versorgungsspannung wird dann durch die noch intakten Pufferkondensatoren gepuffert. Handelt es sich um eine große Zahl von parallel geschalteten Reihenschaltungen und fallen nur wenige dieser aus, ergibt sich eine kaum reduzierte Gesamtkapazität der Parallelschaltung gegenüber dem Fall, in dem alle Kondensatoren intakt sind.

Die Pufferschaltung ist genau so dimensioniert wie die Speicherzellen, wobei sich die einzelnen Reihenschaltungen der Pufferschaltung von den Speicherzellen nur durch die Art und Weise ihrer elektrischen Verbindung unterscheiden. Da die Speicherzellen von Speicherschaltungen stets flächenoptimiert gestaltet werden, erhält man auf diese Weise ohne großen Aufwand eine flächenoptimierte Anordnung der Pufferschaltung. Die Herstellung der Pufferschaltung kann mit nur geringen Änderungen unter Verwendung des Layouts der Speicherzellen erfolgen.

Die Erfindung wird im folgenden anhand von in den Figuren gezeigten Ausführungsbeispielen näher erläutert.
- Figur 1: zeigt eine Pufferschaltung, die nicht durch die Ansprüche gedecht ist,
- Figuren 2 und 3: zeigen Ausführungsbeispiele der Pufferschaltungen, wie sie im erfindungsgemäßen Speicher verwendet werden.
- Figur 4: zeigt eine DRAM-Speicherzelle;
- Figuren 5 bis 7: zeigen Ausführungsformen der Pufferschaltung mit verschiedenen Steuerschaltungen.

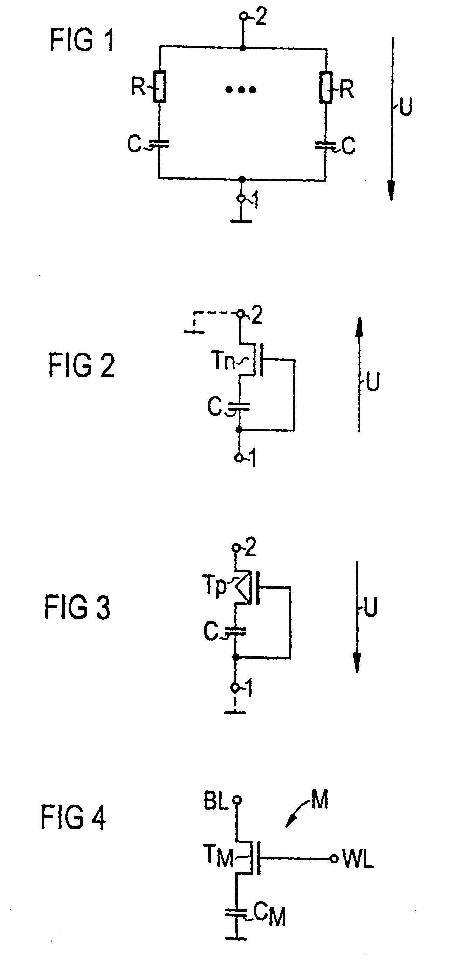

Figur 1 zeigt ein Beispiel einer Pufferschaltung, die nicht durch die Anprüche gedecht ist, bei dem zwischen einem ersten Potentialknoten 1 und einem zweiten Potentialknoten 2 eine zu puffernde Versorgungsspannung U einer integrierten Schaltung abfällt, deren Bestandteil die Pufferschaltung ist. Zwischen den beiden Potentialknoten 1, 2 ist eine Vielzahl von einander parallel geschalteten Reihenschaltungen angeordnet, die jeweils einen hochohmigen ohmschen Widerstand R und einen Pufferkondensator C aufweisen. In Figur 1 ist der erste Potentialknoten 1 mit Masse verbunden und der zweite Potentialknoten 2 mit einem positiven Versorgungspotential. Bei anderen Beispielen kann das Potential des zweiten Potentialknotens negativ sein, oder die Potentialzuordnung der beiden Potentialknoten 1, 2 kann vertauscht sein.

Wenn die Kapazität der einzelnen Pufferkondensatoren C in Figur 1 sehr gering ist, benötigt man eine große Anzahl der dargestellten Reihenschaltungen, um eine ausreichend große Gesamtkapazität zur Pufferung der Versorgungsspannung U zu erzielen. Beträgt die Kapazität jedes der Kondensatoren C beispielsweise 50 fF benötigt man 500.000 Reihenschaltungen, um eine Gesamtkapazität von etwa 25 nF zu erzielen. Bei anderen Beispielen ist es natürlich auch möglich, lediglich eine der gezeigten Reihenschaltung zur Realisierung der Pufferschaltung vorzusehen.

Der hochohmige Widerstand R dient dazu, bei einem Defekt des ihm zugeordneten Kondensators C, der beispielsweise darin bestehen kann, daß dessen Dielektrikum durch eine Überspannung durchschlagen worden ist, den Strom durch die entsprechende Reihenschaltung zu begrenzen. Der Widerstand der Reihenschaltung ergibt sich dann aus der Summe des Widerstandswertes des Widerstands R, sowie des Kurzschlußwiderstandes des defekten Kondensators C. Haben die Kondensatoren C eine Kapazität von 50 fF, hat es sich als günstig erwiesen, für den Widerstand R einen Widerstandswert von ca. 500 kΩ vorzusehen, um im Defektfall eine ausreichende Strombegrenzung zu erreichen.

Durch die hochohmige Strombegrenzung im erfindungsgemäßen Speicher im Defektfall durch die Widerstände R beeinträchtigen die defekten Reihenschaltungen die Funktionsweise der intakten Reihenschaltungen nicht, so daß die Versorgungsspannung U weiterhin durch die intakten Reihenschaltungen und ihre Pufferkondensatoren C gepuffert wird.

Dadurch, daß man den Wert des Widerstands R sehr groß wählt, ist der im Defektfall über den Kondensator C fließende Strom nahezu unabhängig von dessen in der Regel niedrigen Kurzschlußwiderstand. Allein der hochohmige Widerstand R sorgt für eine signifikante Kurzschlußstrombegrenzung.

Figur 2 zeigt als erstes Ausführungsbeispiel der Pufferschaltung eine der Reihenschaltungen aus Figur 1, bei der der ohmsche Widerstand R durch einen n-Kanal-Transistor Tₙ ersetzt ist, dessen Gate mit dem ersten Potentialknoten 1 verbunden ist. Der Transistor Tₙ ist so dimensioniert, daß er sehr hochohmig ist. Die Pufferschaltung nach Figur 2 eignet sich zur Pufferung von Versorgungsspannungen U, bei denen das Potential am ersten Potentialknoten 1 größer als am zweiten Potentialknoten 2 ist.

Figur 3 zeigt als zweites Ausführungsbeispiel der Pufferschaltung eine Realisierung, die sich von derjenigen in Figur 2 nur hinsichtlich des Typs des hochohmigen Transistors unterscheidet. In Figur 3 handelt es sich um einen P-Kanal-Transistor Tₚ. Diese Schaltung eignet sich zum Puffern einer positiven Versorgungsspannung U zwischen den zweiten Potentialknoten 2 und dem ersten Potentialknoten 1.

Figur 4 zeigt eine Speicherzelle M eines dynamischen Speichers (DRAM). Diese weist zwischen einer Bitleitung BL und Masse eine Reihenschaltung aus einem Auswahltransistor T_{M} und einem Speicherkondensator C_{M} auf. Im gezeigten Fall ist der Auswahltransistor T_{M} vom n-Kanal-Typ. Sein Gate ist mit einer Wortleitung WL des Speichers verbunden. Die Pufferschaltung gemäß Figur 2 wird unter Zuhilfenahme des Designs für die Speicherzelle M in Figur 4 hergestellt. Es ist dann lediglich notwendig, die externen Verbindungen der Speicherzelle M mit der Bitleitung BL, der Wortleitung WL und mit Masse durch die der Figur 2 entnehmbaren elektrischen Verbindungen zu ersetzen. Dabei bleibt die äußere Form des Transistors und des Kondensators sowie deren elektrischen Verbindung zur Herstellung der Reihenschaltung unverändert. Wenn nun die in Figur 4 gezeigte Speicherzelle M bereits elektrisch optimiert und flächenmäßig minimiert worden ist, ergibt sich bei Verwendung ihres nur leicht modifizierten Layouts zur Herstellung der Pufferschaltung in Figur 2 eine ebenfalls elektrisch und flächenmäßig optimierte Pufferschaltung.

Die weiter oben beispielhaft angegebenen Werte (Kapazität des Kondensators C = 25 fF, Widerstand des Transistors Tₙ = 500 kΩ) lassen sich auch beim in Figur 2 gezeigten Gegenstand realisieren. Zur Erzielung einer Gesamtkapazität von 25 nF werden wiederum 500.000 der in Figur 2 gezeigten Reihenschaltungen parallel geschaltet.

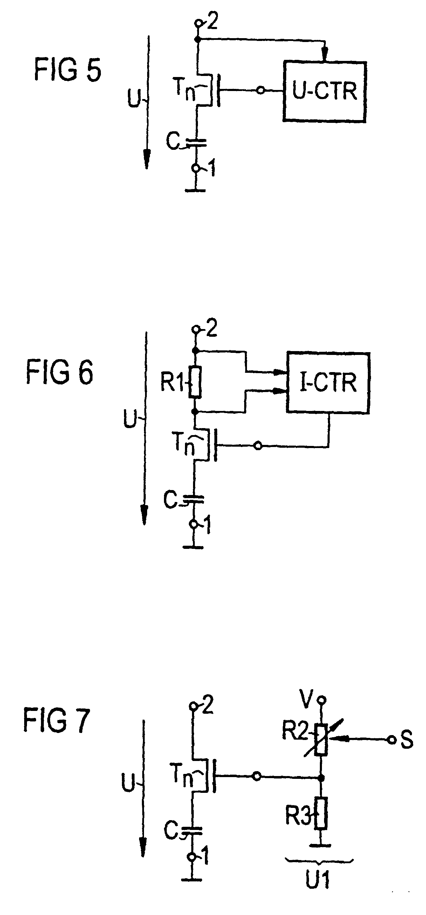

Figur 5 zeigt ein Ausführungsbeispiel der Pufferschaltung, bei der der Widerstandswert des Transistors Tₙ über einen Spannungsregler U-CTR gesteuert wird, dessen Eingang mit dem zweiten Potentialknoten 2 und dessen Ausgang mit dem Steueranschluß des Transistors verbunden ist. Bei einem Defekt des Kondensators C, also bei Auftreten eines Leckstromes in der Reihenschaltung, erhöht der Spannungsregler solange den Widerstandswert, bis der Leckstrom vernachlässigbar klein geworden ist und die zu puffernde Spannung U nicht mehr nennenswert beeinflußt. Im Extremfall sperrt der Spannungsregler den Transistor vollständig, so daß kein Leckstrom mehr durch die Reihenschaltung fließen kann.

Figur 6 zeigt eine Pufferschaltung, bei der der Widerstandswert des Transistors Tₙ von einem Stromregler I-CTR gesteuert wird. Die Reihenschaltung zwischen den beiden Potentialknoten 1, 2 weist einen Meßwiderstand R1 auf, dessen Widerstandswert sehr genau bekannt ist. Ein solcher genau eingestellter Meßwiderstand läßt sich z.B. durch metallische Leiterbahnen realisieren. Der Stromregler erfaßt die über dem Meßwiderstand abfallende Spannung und ermittelt aus dieser und dem (bekannten) Wert des Meßwiderstandes den durch die Reihenschaltung fließenden Strom. Stellt er dabei einen unzulässig hohen Strom fest, der nur von einem Defekt des Kondensators C herrühren kann, erhöht er den Widerstandswert des Transistors solange, bis der Strom einen festgelegten Maximalwert nicht mehr überschreitet. Im Extremfall sperrt der Stromregler den Transistor vollständig.

Figur 7 zeigt eine Pufferschaltung mit einer einstellbaren Spannungsquelle U1, die an ihrem Ausgang, der mit dem Steueranschluß den Transistors Tₙ verbunden ist, eine einstellbare Ausgangsspannung liefert. Die Spannungsquelle U1 ist ein Spannungsteiler aus zwei ohmschen Widerständen R2, R3, von denen einer einen einstellbaren Widerstandswert hat, der über einen Steuereingang S der Spannungsquelle wählbar ist. Das Signal am Steuereingang S ist vom Betreiber der Pufferschaltung vorgebbar. Es kann beispielsweise durch programmierbare Elemente (z.B. Fuses) eingestellt werden. Die Einstellung kann beispielsweise in Abhängigkeit vom Herstellungsprozeß erfolgen, so daß der Widerstandswert des Transistors unabhängig vom Herstellprozeß ist. Der Einfluß des Herstellungsprozesses auf die elektrischen Eigenschaften des Transistors ist z.B. mittels auf dem gleichen Wafer wie die Pufferschaltung hergestellter Teststrukturen feststellbar.

## Patentansprüche

1. Integrierter Speicher
- mit zwei Potentialknoten (1, 2), an denen eine Versorgungsspannung (U) anliegt,
- und mit Speicherzellen (M), die je einen Auswahltransistor (TM) und einen Speicherkondensator (CM) beinhalten,
**gekennzeichnet durch**
- wenigstens eine zwischen den beiden Potentialknoten (1, 2) angeordnete Reihenschaltung jeweils wenigstens eines Pufferkondensators (C) und eines Transistors (Tₙ; Tₚ),
- wobei der Transistor zur Strombegrenzung im Falle eines Defektes des Kondensators dient,
- wobei jeder Pufferkondensator (C) und sein zugehöriger Transistor (Tₙ; Tₚ) bezüglich ihrer gegenseitigen Anordnung und ihren Abmessungen wie die Komponenten (CM, TM) einer der Speicherzellen (M) ausgebildet sind und sich von diesen nur **durch** die Art und Weise ihrer elektrischen Verbindungen unterscheiden.

2. Integrierter Speicher nach Anspruch 1,
bei dem der Steueranschluß des Transistors (Tₙ; Tₚ) mit dem ersten Potentialknoten (1) verbunden ist.

3. Integrierter Speicher nach Anspruch 2,
bei dem der Transistor ein Feldeffekttransistor vom n-Kanal-Typ (Tₙ) ist und bei der das Potential am ersten Potentialknoten (1) größer als am zweiten Potentialknoten (2) ist.

4. Integrierter Speicher nach Anspruch 2,
bei dem der Transistor ein Feldeffekttransistor vom p-Kanal-Typ (Tₚ) ist und bei der das Potential am ersten Potentialknoten (1) kleiner als am zweiten Potentialknoten (2) ist.

5. Integrierter Speicher nach Anspruch 1,
mit einer Steuerschaltung (U-CTR; I-CTR), die den Widerstandswert wenigstens eines der Transistoren (Tₙ; Tₚ) über seinen Steueranschluß steuert.

6. Integrierter Speicher nach Anspruch 5,
bei dem die Steuerschaltung ein Spannungsregler (U-CTR) ist, der den Widerstandswert des wenigstens einen Transistors (Tₙ; Tₚ) in Abhängigkeit vom Potential am zweiten Potentialknoten (2) steuert.

7. Integrierter Speicher nach Anspruch 5,
bei dem die Steuerschaltung ein Stromregler (I-CTR) ist, der den Widerstandswert des wenigstens einen Transistors (Tₙ; Tₚ) in Abhängigkeit vom Stromfluß durch die entsprechende Reihenschaltung steuert.

8. Integrierter Speicher nach Anspruch 5,
bei dem die Steuerschaltung eine einstellbare Spannungsquelle (U1) ist, die an ihrem Ausgang eine über einen Steuereingang einstellbare Ausgangsspannung erzeugt, wobei der Ausgang mit dem Steueranschluß des wenigstens einen Transistors (Tₙ; Tₚ) verbunden ist.

## Claims

1. Integrated memory
- having two potential nodes (1, 2), at which a supply voltage (U) is present,
- and having memory cells (M) each comprising a selection transistor (TM) and a storage capacitor (CM),
**characterized by**
- at least one series circuit formed by in each case at least one buffer capacitor (C) and one transistor (Tₙ; Tₚ), the said series circuit being arranged between the two potential nodes (1, 2),
- where the transistor serves to effect current limiting in the event of a defect in the capacitor,
- where each buffer capacitor (C) and its associated transistor (Tₙ; Tₚ) are designed, with regard to their mutual arrangement and their dimensions, like the components (CM, TM) of one of the memory cells (M) and differ from the latter only by the way in which they are electrically connected.

2. Integrated memory according to Claim 1, in which the control terminal of the transistor (Tₙ; Tₚ) is connected to the first potential node (1).

3. Integrated memory according to Claim 2,
in which the transistor is a field-effect transistor of the n-channel type (Tₙ), and in which the potential at the first potential node (1) is greater than that at the second potential node (2).

4. Integrated memory according to Claim 2,
in which the transistor is a field-effect transistor of the p-channel type (Tₚ), and in which the potential at the first potential node (1) is less than that at the second potential node (2).

5. Integrated memory according to Claim 1,
with a control circuit (U-CTR; I-CTR), which controls the resistance of at least one of the transistors (Tₙ; Tₚ) via its control terminal.

6. Integrated memory according to Claim 5,
in which the control circuit is a voltage regulator (U-CTR), which controls the resistance of the at least one transistor (Tₙ; Tₚ) in a manner dependent on the potential at the second potential node (2).

7. Integrated memory according to Claim 5,
in which the control circuit is a current regulator (I-CTR), which controls the resistance of the at least one transistor (Tₙ; Tₚ) in a manner dependent on the current flow through the corresponding series circuit.

8. Integrated memory according to Claim 5,
in which the control circuit is an adjustable voltage source (U1), which, at its output, generates an output voltage which is adjustable via a control input, the output being connected to the control terminal of the. at least one transistor (Tₙ; Tₚ).

## Revendications

1. Mémoire intégrée :
- comprenant deux noeuds (1, 2) de potentiel auxquels s'applique une tension (U) d'alimentation,
- et comprenant des cellules (M) de mémoire qui comportent respectivement un transistor (TM) de sélection et un condensateur (CM) de mémoire,
**caractérisée par**
- au moins un circuit série monté entre les deux noeuds (1, 2) de potentiel et constitué respectivement d'au moins un condensateur (C) tampon et d'un transistor (Tₙ ; Tₚ),
- le transistor servant à limiter le courant dans le cas d'un défaut du condensateur,
- chaque condensateur (C) tampon et son transistor (Tₙ; Tₚ) associé étant constitué en ce qui concerne leur position mutuelle et leur dimension comme les composants (CM, TM) de l'une des cellules (M) de mémoire et se distinguant de ceux-ci par la façon dont sont réalisées leurs liaisons électriques.

2. Mémoire intégrée suivant la revendication 1, dans laquelle la borne de commande du transistor (Tₙ ; Tₚ) est reliée au premier noeud (1) de potentiel.

3. Mémoire intégrée suivant la revendication 2, dans laquelle le transistor est un transistor à effet de champ de type à canal n (Tₙ) et dans laquelle le potentiel appliqué au premier noeud (1) de potentiel est plus grand que celui appliqué au deuxième noeud (2) de potentiel.

4. Mémoire intégrée suivant la revendication 2, dans laquelle le transistor est un transistor à effet de champ de type à canal p (Tₚ) et dans laquelle le potentiel appliqué au premier noeud (1) de potentiel est plus petit que celui appliqué au deuxième noeud (2) de potentiel.

5. Mémoire intégrée suivant la revendication 1, comprenant :
- un circuit (U-CTR ; I-CTR) de commande, qui commande la valeur de la résistance d'au moins l'un des transistors (Tₙ ; Tₚ) par sa borne de commande.

6. Mémoire intégrée suivant la revendication 5, dans laquelle le circuit de commande est un régleur (U-CTR) de tension, qui commande la valeur de la résistance du au moins un transistor (Tₙ; Tₚ) en fonction du potentiel appliqué au deuxième noeud (2) de potentiel.

7. Mémoire intégrée suivant la revendication 5, dans laquelle le circuit de commande est un régleur (I-CTR) de courant, qui commande la valeur de la résistance du au moins un transistor (Tₙ; Tₚ) en fonction du flux du courant passant dans le circuit série correspondant.

8. Mémoire intégrée suivant la revendication 5, dans laquelle le circuit de commande est une source (U1) de tension, qui est réglable et qui produit à sa sortie une tension de sortie pouvant être réglée par une entrée de commande, la sortie étant reliée à la borne de commande du au moins un transistor (Tₙ ;Tₚ).
